# EUROPEAN PATENT APPLICATION

(11) **EP 4 746 607 A1**
(43) Date of publication of application: **20.05.2026**
(21) Application number: 24826861.7
(22) Date of filing: 26.02.2024
(51) Int. Cl.: H05K 7/20, F16L 41/03

(54) **LIQUID COOLING SERVER CABINET WATER DISTRIBUTOR**

(30) Priority: 10.07.2023 CN 202310842719
(71) Applicant: CHINA MOBILE GROUP DESIGN INSTITUTE CO., LTD., Beijing 100080 (CN); China Mobile Communications Group Co., Ltd, Beijing 100032 (CN)
(72) Inventor: LUO, Hailiang, Beijing 100080 (CN); TIAN, Zeqi, Beijing 100080 (CN); GAO, Yingbo, Beijing 100080 (CN); LIU, Hong, Beijing 100080 (CN); LI, Haibin, Beijing 100080 (CN); WANG, Tiecheng, Beijing 100080 (CN); WANG, Xuejun, Beijing 100080 (CN); LI, Jinfeng, Beijing 100080 (CN); CHENG, Lei, Beijing 100080 (CN); ZHAO, Jinming, Beijing 100080 (CN); CHEN, Bohua, Beijing 100080 (CN); WANG, Yunze, Beijing 100080 (CN); ZHANG, Yanqiu, Beijing 100080 (CN)
(74) Representative: Maiwald GmbH
(86) International application number: PCT/CN2024/078616
(87) International publication number: WO 2025/011036

(57) **Abstract**

A water distributor of a liquid-cooling cabinet includes a pipeline main body, a liquid-outlet joint and a liquid-inlet joint, wherein the pipe wall of the pipeline main body is provided with a plurality of branch-pipeline joints for externally connecting a cooling distribute unit; One end of the liquid-outlet joint and one end of the liquid-inlet joint are respectively connected with two ends of the pipeline main body, and the other end of the liquid-outlet joint and the other end of the liquid-inlet joint are mutually insertable; When the liquid-outlet joint is inserted with the liquid-inlet joint of the water distributor of the adjacent liquid-cooling cabinet, the liquid-outlet joint and the liquid-inlet joint are communicated; The liquid-outlet joint and the liquid-inlet joint are self-sealing joints.

## Description

### CROSS-REFERENCE TO RELATED APPLICATIONS

The present application is based on and claims the priority of Chinese patent application No. 202310842719.9 filed on July 10, 2023, the entire contents of which are incorporated herein by reference.

### FIELD

The present application relates to the technical field of liquid-cooling devices, in particular to a water distributor of a liquid-cooling cabinet.

### BACKGROUND

Cold-plate liquid cooling is the mainstream of liquid cooling technology at present, and its working principle is installing a cold plate in the server to communicate with chips, a GPU and other heating components in the server through pipelines; Coolant flows in the communicated pipeline, and the heat of the heating components is absorbed and taken away by the coolant through the heat exchange of contact between the heat exchange component on the cold plate and the heating component. Cold-plate liquid cooling cabinet is mainly composed of a liquid cooling pipeline, a water distributor, a cooling distribute unit (CDU) and related supporting connecting pieces.

In the related art, a water distributor of a liquid-cooling cabinet is basically full-sized, and the water distributor is divided into a liquid inlet pipeline and a liquid outlet pipeline, which are respectively connected to respective main pipelines, and the main pipelines are connected with CDU. The water distributor of cold-plate liquid-cooling cabinet is mostly integrated, because various servers have different heights, it is necessary to determine the type and size of the servers in the cabinet in advance, and then customize the corresponding water distributors. For example, 2U, 3U or 4U servers need to increase the spacing between branches of the water distributors, which leads to the decrease of the flexibility of the cabinet and that a single cabinet can only install servers of the same size or the location and number of servers of different sizes need to be determined in advance, and the types of servers that will be install on the cabinet later will also be limited by the installed water distributors.

Therefore, it has become an urgency for skills in the field to develop a water distributor of a liquid-cooling cabinet to solve the technical defects of poor universality, complex assembly and easy liquid leakage in the related art.

### SUMMARY

Based on the above description, it is necessary to provide a modularized water distributor of a liquid-cooling cabinet to solve the problems of poor universality, complex assembly and easy leakage in the related art.

Embodiments of the present application provide a water distributor of a liquid-cooling cabinet, including a pipeline main body, a liquid-outlet joint and a liquid-inlet joint, and the pipe wall of the pipeline main body is provided with a branch-pipeline joint, which is configured to externally connect a cooling distribute unit; one end of the liquid-outlet joint and one end of the liquid-inlet joint are respectively connected with two ends of the pipeline main body, and the other end of the liquid-outlet joint and the other end of the liquid-inlet joint are mutually insertable; when the liquid-outlet joint of the water distributor of a liquid-cooling cabinet is inserted with a liquid-inlet joint of an adjacent water distributor of a liquid-cooling cabinet, the liquid-outlet joint is communicated with the liquid-inlet joint of the adjacent water distributor of a liquid-cooling cabinet; and the liquid-outlet joint and the liquid-inlet joint are self-sealing joints.

In an embodiment, the liquid-inlet joint includes a movable valve core, a first valve body, a first elastic piece and a first positioning ring, wherein the first valve body is of a hollow structure, the movable valve core is movable inside the first valve body, and two ends of the first valve body are respectively connected with the movable valve core and the first positioning ring, and the first elastic piece is provided inside the first valve body, two ends of the first elastic piece are respectively abutted against the movable valve core and the first positioning ring, and the movable valve core is matched with the first valve body for blocking the liquid-inlet joint; the liquid-outlet joint includes a movable sealing piece, a valve stem, a second valve body, a second elastic piece and a second positioning ring, wherein the second valve body is of a hollow structure; the valve stem is provided inside the second valve body; two ends of the valve stem are respectively connected with the movable sealing piece and the second elastic piece; the other end of the second elastic piece abuts against the second positioning ring; and the movable sealing piece is matched with the second valve body for blocking the liquid-outlet joint; when the liquid-outlet joint is inserted with the liquid-inlet joint of the adjacent water distributor of a liquid-cooling cabinet, the valve stem and the second valve body of the liquid-inlet joint enter the cavity of the first valve body, and the valve stem pushes the movable valve core to move to the inside of the first valve body; the liquid-inlet joint is connected with the pipeline main body through the first valve body, and the liquid-outlet joint is connected with the pipeline main body through the second valve body.

In an embodiment, the valve stem has a structure in which cross-sectional areas of two ends of the valve stem are both larger than that of the middle of the valve stem, and a connecting end of the valve stem connected with the second elastic piece is provided with an end plate with a through hole, and the through hole is configured for the flow of liquid.

In an embodiment, the liquid-inlet joint further includes a first sealing ring, and the first sealing ring is provided at the connecting part of the movable valve core and the first valve body.

In an embodiment, the liquid-outlet joint includes a second sealing ring and a third sealing ring, wherein the second sealing ring is provided at the connecting part of the movable sealing piece and the second valve body, and the third sealing ring is provided at the gap between the valve stem and the second valve body.

In an embodiment, one end of the pipeline main body is provided with a snap-protrusion, and the other end of the pipeline main body is provided with a snap-slot, and the snap-protrusion is insertable into a snap-slot of an adjacent pipeline main body.

In an embodiment, the snap-protrusion and the snap-slot are staggered.

The number of the snap-slots is four, and adjacent snap-slots are provided at equal intervals; and the snap-protrusion is in one-to-one correspondence with the snap-slot.

In an embodiment, the pipeline main body is detachably connected with the liquid-inlet joint, and the pipeline main body is detachably connected with the liquid-outlet joint.

In an embodiment, the water distributor of a liquid-cooling cabinet further includes a sealing joint, which is connectable with any end of the pipeline body.

In an embodiment, the water distributor of a liquid-cooling cabinet further includes a connecting joint, which fixes a plurality of pipeline bodies during transportation, wherein one end of the connecting joint is connected with the pipeline body, and the other end of the connecting joint is connected with an adjacent pipeline body.

To sum up, embodiments of the present application provide a water distributor of a liquid-cooling cabinet, which includes a pipeline main body, a liquid-outlet joint and a liquid-inlet joint, and the pipe wall of the pipeline main body is provided with a plurality of branch-pipeline joints for externally connecting a cooling distribute unit; One end of the liquid-outlet joint and one end of the liquid-inlet joint are respectively connected with two ends of the pipeline main body, and the other end of the liquid-outlet joint and the other end of the liquid-inlet joint can be mutually inserted; when the liquid-outlet joint and the liquid-inlet joint are inserted with each other, the liquid-outlet joint and the liquid-inlet joint are communicated; The liquid-outlet joint and the liquid-inlet joint are self-sealing joints. In the technical solution provided by embodiments of the present application, when the liquid-inlet joint and the liquid-outlet joint are not inserted with each other, they are in a state of self-inserting, and the liquid inside cannot flow out; When the liquid-inlet joint and the liquid-outlet joint are inserted with each other, the liquids can flow and communicate, therefore, when building the water distributor structure, it can be built without other components, and the installation is simple and convenient; At the same time, it can be spliced according to the actual use requirements, and there is no need to customize a specific template with its strong versatility; Thirdly, the use of complex connecting structures is reduced, which can effectively reduce the problem of liquid leakage caused by connection damage of complex connecting pieces.

### BRIEF DESCRIPTION OF THE DRAWINGS

FIG. 1 is a schematic cross-sectional structural view of a water distributor of a liquid-cooling cabinet in the technical solution provided by an embodiment of the present application;
FIG. 2 is another cross-sectional structural schematic view of a water distributor of a liquid-cooling cabinet in the technical solution provided by an embodiment of the present application;
FIG. 3 is an explosion view of a liquid-inlet joint in a water distributor of a liquid-cooling cabinet provided by an embodiment of the present application;
FIG. 4 is an explosion view of a liquid-outlet joint in a water distributor of a liquid-cooling cabinet provided by an embodiment of the present application;
FIG. 5 is a schematic cross-sectional view of the connecting part of water distributors of adjacent liquid-cooling cabinets in the technical solution provided by an embodiment of the present application;
FIG. 6 is a partially enlarged schematic view of the connecting part of water distributors of adjacent liquid-cooling cabinets in the technical solution provided by an embodiment of the present application;
FIG. 7 is a schematic view of a connection state of a water distributor of a liquid-cooling cabinet in the technical solution provided by an embodiment of the present application;
FIG. 8 is a structural schematic views of one of assembled water distributors of a liquid-cooling cabinet in the technical solution provided by an embodiment of the present application;
pipeline body-1, liquid-outlet joint- 2, liquid-inlet joint- 3, branch-pipeline joint- 4, sealing joint- 5, connecting joint- 6, first sealing ring- 7, movable valve core- 8, first valve body- 9, first elastic piece- 10, first positioning ring- 11, second sealing ring- 12, movable sealing piece- 13, valve stem- 14, third sealing ring- 15, second valve body- 16, second elastic piece- 17, second positioning ring-18, snap-protrusion- 19, snap-slot- 20.

### DETAILED DESCRIPTION

In order to make the above objects, features and advantages of the present application more obvious and easy to understand, the specific embodiments of the present application will be described in detail with the attached drawings. In the following description, numerous specific details are set forth in order to provide a thorough understanding of the present application. However, the present application can be implemented in many other ways different from those described here, and those skilled in the art can make similar improvements without violating the connotation of the present application, so the present application is not limited by the specific embodiments disclosed below.

In the description of the present disclosure, it should be understood that the orientation or positional relationship indicated by the terms "center", "longitudinal", "transverse", "length", "width", "thickness", "up", "down", "front", "rear", "left", "right", "vertical", "horizontal", "top", "bottom", "inside", "outside", "clockwise", "counterclockwise", "axial", "radial" and "circumferential" and the like, is based on the orientation or positional relationship shown in the attached drawings, which is only for the convenience of describing the present disclosure and simplifying the description, and does not indicate or imply that the referred device or element must have a specific orientation, and be constructed and operated in a specific orientation, so it cannot be understood as a limitation of the present disclosure.

In addition, the terms "first" and "second" are only used for purpose of description, and cannot be understood as indicating or implying relative importance or implicitly indicating the number of indicated technical features. Therefore, the feature defined as "first" or "second" may explicitly or implicitly include at least one such feature. In the description of the present disclosure, "a plurality of" means at least two, such as two, three, etc., unless otherwise specifically defined.

In the present disclosure, unless otherwise expressly defined, terms such as "install", "interconnect", "connect", "fix" shall be understood broadly, and may be, for example, fixed connections, detachable connections, or integral connections; may also be mechanical or electrical connections or intercommunication; may also be direct connections or indirect connections via intervening media; may also be inner communications or interactions of two elements, unless otherwise specified. For those skilled in the art, the specific meanings of the above terms in the present disclosure can be understood in specific situations.

In the present disclosure, unless otherwise expressly defined and specified, a structure in which a first feature is "on" or "below" a second feature may include an embodiment in which the first feature is in direct contact with the second feature, or may further include an embodiment in which the first feature and the second feature are in indirect contact through intermediate media. Furthermore, a first feature "on", "above", or "on top of" a second feature may include an embodiment in which the first feature is right or obliquely "on", "above", or "on top of" the second feature, or just means that the first feature is at a height higher than that of the second feature, while a first feature "below", "under", or "on bottom of" a second feature may include an embodiment in which the first feature is right or obliquely "below", "under", or "on bottom of" the second feature, or just means that the first feature is at a height lower than that of the second feature.

It should be noted that when an element is said to be "fixed to" or "provided in" another element, it can be directly on the other element or there can be intervening elements. When an element is considered to be "connected" to another element, it may be directly connected to another element or intervening elements may exist at the same time. The terms "perpendicular", "horizontal", "up", "down", "left" and "right" and similar expressions used in this paper are only for the purpose of illustration, and do not represent the only embodiment.

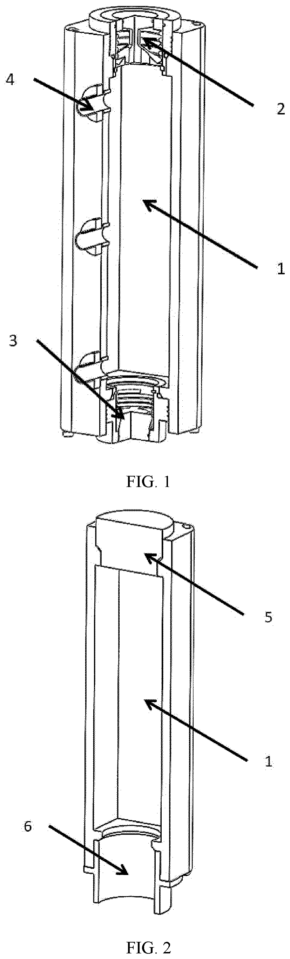

Referring to FIG. 1, embodiments of the present application provide a water distributor of a liquid-cooling cabinet, which includes a pipeline main body 1, a liquid-outlet joint 2 and a liquid-inlet joint 3, wherein the pipe wall of the pipeline main body 1 is provided with a branch-pipeline joint 4 for externally connecting a cooling distribute unit (CDU); and one end of the liquid-outlet joint 2 and one end of the liquid-inlet joint 3 are respectively connected with two ends of the pipeline main body 1, and the other end of the liquid-outlet joint 2 and the other end of the adjacent liquid-inlet joint 3 can be inserted with each other; When the liquid-outlet joint 2 and the liquid-inlet joint 3 are inserted with each other, the liquid-outlet joint 2 and the liquid-inlet joint 3 are communicated; The liquid-outlet joint 2 and the liquid-inlet joint 3 are self-sealing joints.

In the technical solution provided by embodiments of the present application, the liquid-inlet joint 3 of the water distributor of a liquid-cooling cabinet is connected with the liquid-outlet joint 2 of the adjacent water distributor of a liquid-cooling cabinet, and the liquid-inlet joint 3 of the adjacent water distributor of a liquid-cooling cabinet is connected with the liquid-outlet joint 2 of another water distributor of a liquid-cooling cabinet, so that the whole water distribution pipeline can be built by end-to-end connection. At this time, the liquid flow communication is realized through the insides of the liquid-outlet joint 2 and the liquid-inlet joint 3, and then refrigeration is completed through the CDU.

Under the condition that the liquid-inlet joint 3 or the liquid-outlet joint 2 at both ends of the pipeline body are not inserted with other joints, the liquid will be confined in the water distributor of the liquid-cooling cabinet and will not flow out because the liquid-outlet joint 2 and the liquid-inlet joint 3 are of self-sealing structure.

In the process of practical application, the whole water distribution pipeline can be built simply and conveniently by modularized splicing according to the actual use requirements, just like "building blocks"; At the same time, because of its simple structure, compared with the traditional water distribution pipeline structure, the water distributor of a liquid-cooling cabinet of the present application will occupy less space and be more convenient to disassemble, assemble and operate.

Under the condition that the operation requirements for the server change, the modularized water distributor of a liquid-cooling cabinet can be flexibly installed and disassembled. When one water distributor of a liquid-cooling cabinet is removed, the liquid-outlet joint 2 or the liquid-inlet joint 3 of this water distributor of a liquid-cooling cabinet will be automatically blocked, so the water distributor of a liquid-cooling cabinet can be disassembled without stopping the server. After requirements for the server is changed, it is only necessary to replace with the water distributor with a module structure that matches the server's specifications.

Compared with the water distributor in the related art, the modularized water distributor of a liquid-cooling cabinet has the following advantages, firstly, the water distributor is modularized and can be disassembled and assembled at will, and the disassembly process and assembly process is simple and fast, which can greatly reduce the cost of operation and maintenance; Secondly, more diversified modules can be built according to the actual use requirements, without customization of the water distributor, and the installation cost can be greatly reduced while the water distributors can be flexibly combined according to the actual operation to meet the requirements, thus; Thirdly, in the related art, most water distributors are provided with centralized modules and branch modules, which are connected by connecting plugs, and such a complicated structure will greatly improve the occurrence rate of liquid leakage, however, the connecting principle of the technical solution of the present application is different from that of the related art, and there are no complicated connecting components in the present application, so that the probability of liquid leakage is greatly reduced.

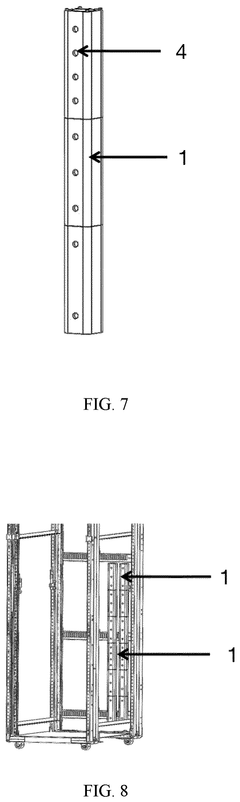

Here, referring to FIG. 7 and FIG. 8. In the technical solution provided by embodiments of the present application, the technical solution of FIG. 7 and FIG. 8 are in the present application scenario of one of the water distribution pipelines constructed by connecting the modularized water distributors of liquid-cooling cabinet end-to-end. However, the applicant here emphasizes that this is only a concrete display of the application scenario according to one of the technical solutions of the present application, and does not constitute a limitation on the protection solutions of the present application.

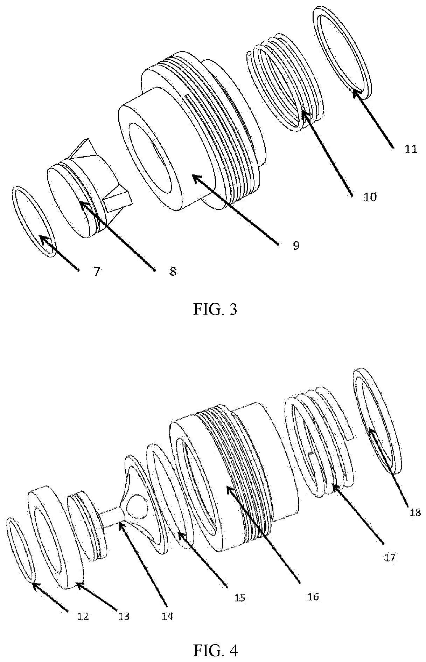

Referring to FIG. 3 to FIG. 5, the structures of the liquid-outlet joint 2 and the liquid-inlet joint 3 will be described in detail in combination with the explosion views of the liquid-outlet joint 2 and the liquid-inlet joint 3 and the cross-sectional views after the connection of the liquid-outlet joint 2 and the liquid-inlet joint 3 is completed.

As described in embodiments of the present application, a first elastic piece 10 and a second elastic piece 17 may be springs or other types of elastic pieces, which will not be described in detail later.

In an embodiment, the liquid-inlet joint 3 includes a movable valve core 8, a first valve body 9, a first elastic piece 10 and a first positioning ring 11, wherein the first valve body 9 is in a hollow structure, the first positioning ring 11 is located in the first valve body 9 and is fixedly provided at one end of the first valve body 9 connected with the pipeline main body 1, and the movable valve core 8 can move in the first valve body 9, and both ends of the first valve body 9 are respectively connected with the movable valve core 8 and the first positioning ring 11. The first elastic piece 10 is provided in the first valve body 9, and both ends of the first elastic piece 10 respectively abut against the movable valve core 8 and the first positioning ring 11, and the movable valve core 8 cooperates with the first valve body 9 to block or conduct the liquid-inlet joint 3.

In the structure of the liquid-inlet joint 3, the liquid-inlet joint 3 is connected with the pipeline main body 1 through the outer wall of the first valve body 9, and the movable valve core 8 is blocked at the outer side of the first valve body 9 under the action of the first elastic piece 10 when the liquid-inlet joint 3 is not subjected to external pressure, and at this time, the connecting surface between the movable valve core 8 and the outer side of the first valve body 9 is closed, and the liquid flowing through the first valve body 9 is blocked. The first positioning ring 11 abuts against the other end of the first elastic piece 10 to ensure that the first elastic piece 10 only compresses under the external force and prevent the first elastic piece 10 from moving under the external force.

The liquid-outlet joint 2 includes a movable sealing piece 13, a valve stem 14, a second valve body 16, a second elastic piece 17 and a second positioning ring 18, wherein the second valve body 16 is in a hollow structure, the second positioning ring 18 is provided inside the second valve body 16 and is fixedly provided at one end of the second valve body 16 connected with the pipeline main body 1, the valve stem 14 is in a structure, in which the cross-sectional area at both ends larger than the cross-sectional area of the middle part, and the movable sealing piece 13 is of a hollow structure. The valve stem 14 is fixedly provided in the second valve body 16, one end of the valve stem 14 abuts against the second positioning ring 18, the other end of the valve stem 14 is in the hollow structure of the movable sealing piece 13 and connected with the movable sealing piece 13; and the second elastic piece 17 is provided between the two end faces of the valve stem 14, and one end of the second elastic piece 17 abuts against the movable sealing piece 13, and the other end of the second elastic piece 17 abuts against the end face of the valve stem 14 which abuts against the second positioning ring 18. The cross-sectional area of the movable sealing piece 13 is the same as that of the first valve body 9, and the movable sealing piece 13 can move between the two end faces of the valve stem 14. The movable sealing piece 13 and the valve stem 14 match with the second valve body 16 to block or conduct the liquid-outlet joint 2.

In the structure of the liquid-outlet joint 2, the liquid-outlet joint 2 is connected with the pipeline main body 1 through the outer wall of the second valve body 16, and under the condition that the liquid-outlet joint 2 is not subjected to external pressure, the movable sealing piece 13 is blocked at the outer side of the second valve body 16 under the action of the second elastic piece 17; At this time, the connecting surface between the movable sealing piece 13 and the outer side of the second valve body 16 is closed, and the liquid flowing through the second valve body 16 is blocked. The second positioning ring 18 abuts against the other end of the second elastic piece 17 to ensure that the second elastic piece 17 only compresses under the external force and prevent the second elastic piece 17 from moving under the external force.

The above structural description, combined with the structure of the explosion schematic view, explains the self-sealing principle of the liquid-inlet joint 3 and the liquid-outlet joint 2 respectively. Next, when the liquid-inlet joint 3 and the liquid-outlet joint 2 are inserted with each other, the liquid circulation principle after their inserting is explained in combination with the characteristics of each structure of the liquid-inlet joint 3 and the liquid-outlet joint 2.

When inserting, the valve stem 14 and the second valve body 16 can enter the cavity of the first valve body 9, and the valve stem 14 pushes the movable valve core 8 to move towards the inside of the first valve body 9.

When the inserting begins, and after the liquid-outlet joint 2 contacts the liquid-inlet joint 3, the force is continuously applied, and the end faces of the liquid-outlet joint 2 and the liquid-inlet joint 3 are pressed, and at this time, the movable sealing piece 13 of the liquid-outlet joint 2 is moved in the direction of the second positioning ring 18 under the action of the first valve body 9, therefore, the second spring 17 of the liquid-outlet joint 2 is compressed, and the first valve body 9 of the liquid-inlet joint 3 enters into the second valve body 16 of the liquid-outlet joint 2. At the same time, under the action of the valve stem 14 of the liquid-outlet joint 2, the movable valve core 8 of the liquid-inlet joint 3 will move in the direction of the first positioning ring 11, and the first spring 10 of the liquid-inlet joint 3 will also be compressed, and the valve stem 14 of the liquid-outlet joint 2 will enter the cavity of the first valve body 9 of the liquid-inlet joint 3.

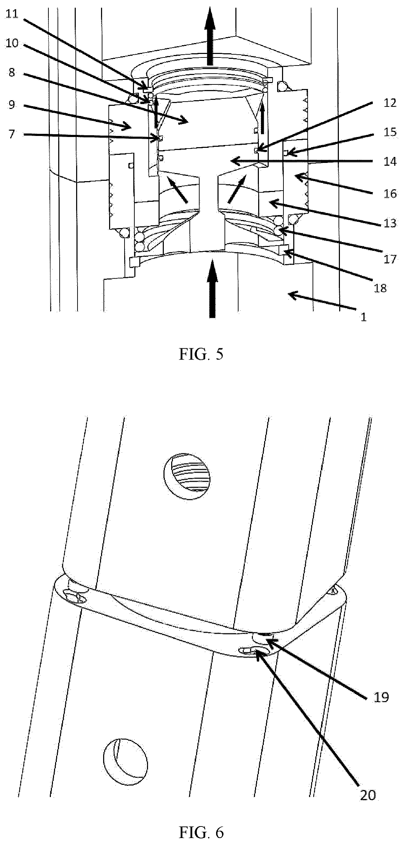

At this time, the whole liquid flow passage is opened, and the liquid first enters into the cavity of the second valve body 16 of the liquid-outlet joint 2 through the pipeline main body 1, and then flows into the cavity of the first valve body 9 of the liquid-inlet joint 3 through the cavity generated at the contact between the liquid-outlet joint 2 and the liquid-inlet joint 3, so as to realize the circulation of the liquid. The whole process is shown by the arrow in FIG. 5.

Further optimizing the technical solution, the shape of the valve stem 14 is in a structure, in which the cross-sectional area of both ends is larger than the cross-sectional area of the middle part, and the connecting end of the valve stem 14 connected with the second elastic piece 17 is provided with an end disk with a through hole for the circulation of liquid. The structure of larger cross-sectional area at both ends of the valve stem 14 can increase the contact areas between the two ends of the valve stem 14 and the movable sealing piece 13 and the second spring 17, which can make the parts not easy to slip during the end face extrusion; At the same time, the structure with small cross-sectional area in the middle of the valve stem 14 forms a cavity with larger capacity between the valve stem 14 and the second valve body 16, which can speed up the passage of liquid; Further, the connecting end of the valve stem 14 connected with the second elastic piece 17 is provided with an end disk with a through hole, and liquid can flow through the through hole, so that the liquid can pass quickly and the larger contact area can be ensured to prevent slipping.

Further optimizing the technical solution, in order to effectively improve the sealability of the self-sealing structure of the liquid-inlet joint 3 and prevent the liquid from flowing out, in the technical solution provided by embodiments of the present application, the liquid-inlet joint 3 further includes a first sealing ring 7, and the first sealing ring 7 is provided at the connecting part of the movable valve core 8 and the first valve body 9.

Similarly, in order to effectively improve the sealability of the self-sealing structure of the liquid-outlet joint 2 and prevent the liquid from flowing out, in the technical solution provided by embodiments of the present application, the liquid-outlet joint 2 includes a second sealing ring 12 and a third sealing ring 15, and the second sealing ring 12 is provided at the connecting part of the movable sealing piece 13 and the valve stem 14, and the third sealing ring 15 is provided at the gap between the valve stem 14 and the second valve body 16.

Referring to FIG. 6, in order to further effectively enhance the connection tightness between adjacent pipeline bodies 1, and at the same time, it is necessary to take into account the practical use requirements of convenient disassembly and assembly, in the technical solution provided by embodiments of the present application, one end of the pipeline body 1 is provided with a snap-protrusion 19, and the other end of the pipeline body 1 is provided with a snap-slot 20. The connection between the snap-protrusion 19 and the snap-slot 20 is used to fix the liquid-outlet joint 2 and the liquid-inlet joint 3, and the snap-protrusion 19 can be inserted into the snap-slot 20 of the pipeline body 1 of the adjacent water distributor of a liquid-cooling cabinet. The structural design of the snap-protrusion 19 and the snap-slot 20 can complete rapid disassembly; At the same time, the installation of the snap-protrusion 19 and the clamp groove 20 is realized by the connection relationship of insertion, which can effectively shorten the connecting gap between adjacent pipeline bodies 1 and enhance the connecting tightness between adjacent pipeline bodies 1.

Further optimizing the technical solution, in the technical solution provided by embodiments of the present application, the snap-protrusion 19 and the snap-slot 20 are provided in a staggered manner. The staggered structural design can realize the locking between the snap-protrusion 19 and the snap-slot 20 by slightly screwing the pipeline main body 1 of the water distributor of the liquid-cooling cabinet after the snap-protrusion 19 is inserted into the snap-slot 20, without relying on external reinforcement structures such as locks, and the installation process is more simplified, and the overall structure after installation is more concise and light.

At the same time, on the basis of considering the connection and fastening of adjacent pipeline bodies 1 and the design concept of simple structural design and improving installation efficiency, in the technical solution provided by embodiments of the present application, the number of snap-protrusions 19 provided at one end of the pipeline body 1 is four, and adjacent snap-protrusions 19 are provided at equal intervals; The number of snap-slots 20 provided on the other end of the pipeline main body 1 is four, and adjacent snap-slots 20 are provided at equal intervals; The snap-protrusion 19 and the snap-slot 20 are in one-to-one correspondence.

In another implementation scenario, in order to further expand the present application scenario of the water distributor of a liquid-cooling cabinet and facilitate the connection of the water distributor of a liquid-cooling cabinet with other possible connecting pieces, in the technical solution provided by embodiments of the present application, the pipeline body 1 is detachably connected with the liquid-inlet joint 3, and the pipeline body 1 is detachably connected with the liquid-outlet joint 2. According to different application scenarios and use requirements, after the pipeline main body 1 is detached from the liquid-outlet joint 2 and/or the liquid-inlet joint 3, and it can be connected with other components.

In order to facilitate the disassembly and installation of the liquid-outlet joint 2 and/or the liquid-inlet joint 3 with the pipeline main body 1, and at the same time, the connection with the pipeline main body 1 is more stable, in the technical solution provided by embodiments of the present application, the liquid-outlet joint 2 and the liquid-inlet joint 3 are connected with the pipeline main body 1 through threads.

Referring to FIG. 2, in order to further optimize the sealing effect at the port under the condition that the pipeline main body 1 is detachable from the liquid-outlet joint 2 and/or the liquid-inlet joint 3, the water distributor of a liquid-cooling cabinet further includes a sealing joint 5, and the sealing joint 5 can be connected with any end of the pipeline main body 1. Under the condition that the port of the water distributor of the liquid-cooling cabinet is externally connected with the sealing joint 5, the technical effect of closing the port of the liquid-cooling cabinet can be achieved.

Similarly, the water distributor of a liquid-cooling cabinet provided by embodiments of the present application further includes a connecting joint 6, and the connecting joint 6 is used for fixing a plurality of pipeline bodies during transportation, one end of the connecting joint 6 is connected with the pipeline bodies 1, and the other end of the connecting joint 6 is connected with the adjacent pipeline bodies 1, which has the advantages of convenient installation and disassembly.

It can be concluded from the above technical solution that the water distributor of a liquid-cooling cabinet provided by embodiments of the present application has the following advantages:
1. The water distributor of a liquid-cooling cabinet provided by embodiments of the present application has the characteristic of modularity, and can be flexibly matched and adjusted according to the actual operation situation and the size, model and height of the server, so that multiple-size servers can be put on the cabinet at the same time, with stronger universality;
2. The modularized water distributor can be disassembled and assembled according to actual needs, and the disassembly process and the assembly process is simple and fast, and the flow passage can be connected after installation, and the flow passage is closed immediately after separation, thus effectively reducing the probability of liquid leakage;
3. Further, the installation can be realized when the server is running, without stopping the server, and at the same time, the installed water distributor and the server on the cabinet will not be affected, thus greatly reducing the cost of operation and maintenance;
4. The detachable design of the liquid-outlet joint and the liquid-inlet joint is more universal, and can be flexibly adjusted according to the actual installation scenario, which is compatible with the server with different interface forms to install on cabinets and does not need to customize the whole machine;
5. Two ends of the pipeline body can be installed with a liquid-outlet joint and a liquid-inlet joint, and can also be installed with a connecting joint for connecting with the pipeline of the CDU, or can be installed with a sealing joint for sealing the uppermost pipeline, and can be installed with an exhaust valve for exhausting air in the pipeline, which can be flexibly adjusted according to the actual situation;

To sum up, embodiments of the present application provides a water distributor of a liquid-cooling cabinet, which includes a pipeline main body, a liquid-outlet joint and a liquid-inlet joint, wherein the pipe wall of the pipeline main body is provided with a plurality of branch-pipeline joints for externally connecting a cooling distribute unit; One end of the liquid-outlet joint and one end of the liquid-inlet joint are respectively connected with two ends of the pipeline main body, and the other end of the liquid-outlet joint can be mutually inserted with the other end of the liquid-inlet joint of the adjacent water distributor of a liquid-cooling cabinet; When the liquid-outlet joint and the liquid-inlet joint are inserted with each other, the liquid-outlet joint and the liquid-inlet joint are communicated; The liquid-outlet joint and the liquid-inlet joint are self-sealing joints. In the technical solution provided by embodiments of the present application, when the liquid-inlet joint and the liquid-outlet joint are not inserted with each other, they are in a state of self-inserting, and the liquid inside of them cannot flow out; When the liquid-inlet joint and the liquid-outlet joint are inserted, the liquid can flow and communicate, so when building the water distributor structure, it can be built without other components, and the installation is simple and convenient; At the same time, it can be spliced according to the actual use requirements, and there is no need to customize a specific template with great universality; Thirdly, the use of complex connecting structures is reduced, which can effectively reduce the problem of liquid leakage caused by damage of connection of complex connecting pieces.

The technical features of the above-mentioned embodiments can be combined arbitrarily. In order to make the description concise, not all possible combinations of the technical features in the above-mentioned embodiments are described. However, as long as there is no contradiction between the combinations of these technical features, they should be considered in the scope recorded in this specification. Meanwhile, other embodiments can be derived from the above embodiments, so that structural and logical substitutions and changes can be made without depart from the scope of the present application.

The above-mentioned embodiments only express several implementations of the present application, and their descriptions are more specific and detailed, but they cannot be understood as limiting the scope of the present invention. It should be pointed out that for those skilled in the art, without departing from the concept of the present application, several modifications and improvements can be made, which are within the protection scope of the present application. Therefore, the scope of protection of the present application shall be subject to the appended claims.

## Claims

1. A water distributor of a liquid-cooling cabinet, comprising: a pipeline main body, a liquid-outlet joint and a liquid-inlet joint, wherein the pipe wall of the pipeline main body is provided with a branch-pipeline joint configured to externally connect to a cooling distribute unit;
one end of the liquid-outlet joint and one end of the liquid-inlet joint are respectively connected with two ends of the pipeline main body, and the other end of the liquid-outlet joint and the other end of the liquid-inlet joint are mutually insertable;
when the liquid-outlet joint is inserted with a liquid-inlet joint of an adjacent water distributor of a liquid-cooling cabinet, the liquid-outlet joint is communicated with the liquid-inlet joint of an adjacent water distributor of a liquid-cooling cabinet; and the liquid-outlet joint and the liquid-inlet joint are self-sealing joints.

2. The water distributor of a liquid-cooling cabinet according to claim 1, wherein the liquid-inlet joint comprises a movable valve core, a first valve body, a first elastic piece and a first positioning ring, the first valve body is of a hollow structure, the movable valve core is movable inside the first valve body, and two ends of the first valve body are respectively connected with the movable valve core and the first positioning ring, and the first elastic piece is provided inside the first valve body, two ends of the first elastic piece are respectively abutted against the movable valve core and the first positioning ring, and the movable valve core is matched with the first valve body for blocking the liquid-inlet joint;
the liquid-outlet joint comprises a movable sealing piece, a valve stem, a second valve body, a second elastic piece and a second positioning ring, wherein the second valve body is of a hollow structure; the valve stem is provided inside the second valve body; two ends of the valve stem are respectively connected with the movable sealing piece and the second elastic piece; the other end of the second elastic piece abuts against the second positioning ring; and the movable sealing piece is matched with the second valve body for blocking the liquid-outlet joint;
when the liquid-outlet joint is inserted with the liquid-inlet joint of the adjacent water distributor of a liquid-cooling cabinet, the valve stem and the second valve body of the liquid-inlet joint enter the cavity of the first valve body, and the valve stem pushes the movable valve core to move to the inside of the first valve body;
the liquid-inlet joint is connected with the pipeline main body through the first valve body, and the liquid-outlet joint is connected with the pipeline main body through the second valve body.

3. The water distributor of a liquid-cooling cabinet according to claim 2, wherein the valve stem has a structure in which cross-sectional area of two ends of the valve stem are both larger than that of the middle part of the valve stem, and a connecting end of the valve stem connected with the second elastic piece is provided with an end plate with a through hole, and the through hole is configured for the flow of liquid.

4. The water distributor of a liquid-cooling cabinet according to claim 2, wherein the liquid-inlet joint further comprises a first sealing ring, and the first sealing ring is provided at the connecting part between the movable valve core and the first valve body.

5. The water distributor of a liquid-cooling cabinet according to claim 2, wherein the liquid-outlet joint comprises a second sealing ring and a third sealing ring, wherein the second sealing ring is provided at the connecting part between the movable sealing piece and the second valve body, and the third sealing ring is provided at the gap between the valve stem and the second valve body.

6. The water distributor of a liquid-cooling cabinet according to claim 2, wherein one end of the pipeline main body is provided with a snap-protrusion, and the other end of the pipeline main body is provided with a snap-slot, and the snap-protrusion is insertable into a snap-slot of an adjacent pipeline main body.

7. The water distributor of a liquid-cooling cabinet according to claim 6, wherein the snap-protrusion and the snap-slot are staggered.

8. The water distributor of a liquid-cooling cabinet according to claim 1, wherein the pipeline main body is detachably connected with the liquid-inlet joint, and the pipeline main body is detachably connected with the liquid-outlet joint.

9. The water distributor of a liquid-cooling cabinet according to claim 8, further comprising a sealing joint, and the sealing joint is connectable with any end of the pipeline body.

10. The water distributor of a liquid-cooling cabinet according to claim 8, further comprising a connecting joint, and the connecting joint fixes a plurality of pipeline bodies during transportation, wherein one end of the connecting joint is connected with the pipeline body, and the other end of the connecting joint is connected with an adjacent pipeline body.
